(19) Europäisches Patentamt / European Patent Office / Office européen des brevets

(11) **EP 1 758 241 A1**

(12) **EUROPEAN PATENT APPLICATION**
published in accordance with Art. 158(3) EPC

(43) Date of publication:
**28.02.2007 Bulletin 2007/09**

(51) Int Cl.:
*H03D 7/18* (2006.01)    *H04B 1/26* (2006.01)

(21) Application number: **05743918.4**

(86) International application number:
**PCT/JP2005/009578**

(22) Date of filing: **25.05.2005**

(87) International publication number:
**WO 2005/119902 (15.12.2005 Gazette 2005/50)**

(84) Designated Contracting States:
**DE FR NL**

(30) Priority: **03.06.2004 JP 2004165638**

(71) Applicant: **Niigata Seimitsu Co., Ltd.**
**Joetsu-shi, Niigata 943-0834 (JP)**

(72) Inventors:
 • **AOYAMA, T.,**
   **KABUSHIKI KAISHA TOYOTA JIDOSHOKKI**
   **Kariya-shi,**
   **Aichi 4488671 (JP)**

 • **MIYAGI, Hiroshi,**
   **NIIGATA SEIMITSU CO. LTD.**
   **Joetsu-shi,**
   **Niigata 9430834 (JP)**

(74) Representative: **Leson, Thomas Johannes Alois**
**Patentanwälte**
**Tiedtke-Bühling-Kinne & Partner,**
**Bavariaring 4**
**80336 München (DE)**

(54)    **IMAGE REMOVING CIRCUIT**

(57)    In order to provide an image rejection circuit that can reject an image signal without being affected by manufacturing variations in circuit elements such as resistors, condensers, or the like, an image rejection circuit is provided which comprises a first mixer unit 2 for mixing a signal received by a receiver device with a first local oscillation signal generated by a local oscillator 1, a second mixer unit 3 for mixing the received signal with a second local oscillation signal obtained by shifting the local oscillation signal generated by the local oscillator 1 by 90°, a polyphase filter circuit 4 including condensers C1 and switched capacitors, and a composition/output unit 5 for composing and outputting the IF signals output from the polyphase filter circuit 4.

FIG. 3A

**Description**

**Technical Field**

The present invention relates to an image rejection circuit for rejecting an image frequency in radio communications.

**Background Art**

In a receiver device used for radio communications, e. g. , a receiver device using a super heterodyne method, a mixer circuit mixes a signal received by the receiver device (an FM signal, an AM signal, or the like, for example) with a local oscillation signal generated by an oscillator included in the receiver device, then an IF (Intermediate Frequency) signal which is obtained by converting the received signal into a signal having a frequency in a lower frequency band is generated.

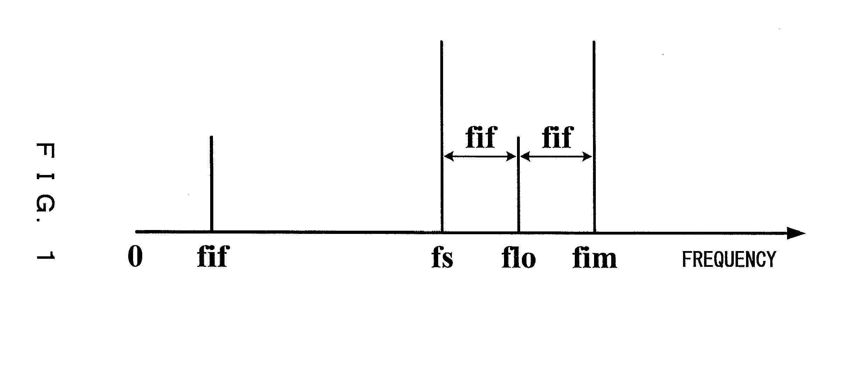

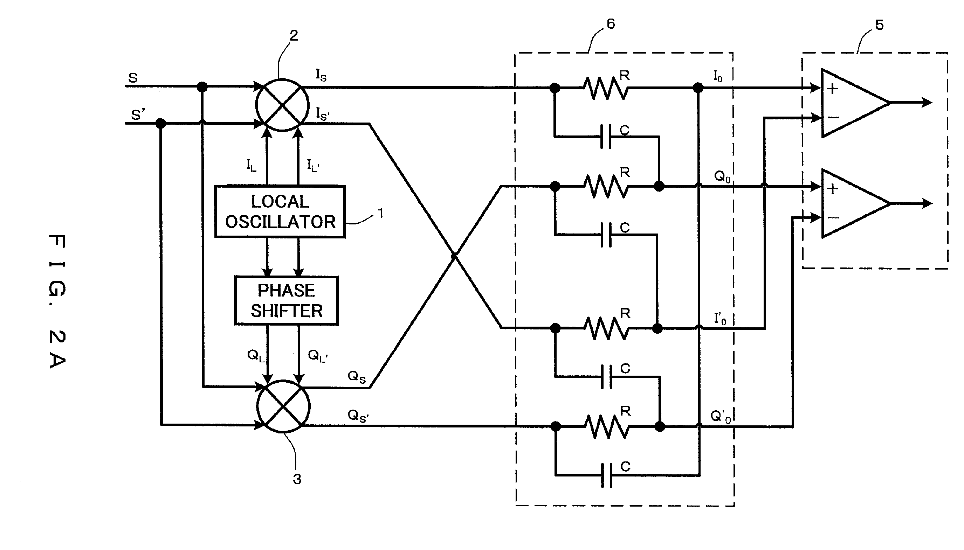

For example, when it is assumed, as shown in Fig. 1, that the frequency of a signal received by a receiver device is fs, and the frequency of a local oscillation signal generated by an oscillator included in the receiver is flo, then a mixer circuit generates an IF signal having a frequency of fif (=flo-fs).

However, when the receiver device receives a signal having a frequency fim that is higher than the frequency (flo) of the local oscillation signal of Fig. 1 by the amount of the frequency fif of the IF signal (hereinafter, this received signal is referred to as an image signal), there occurs a problem in that the mixer circuit generates the IF signal from both the local oscillation signal and the image signal.

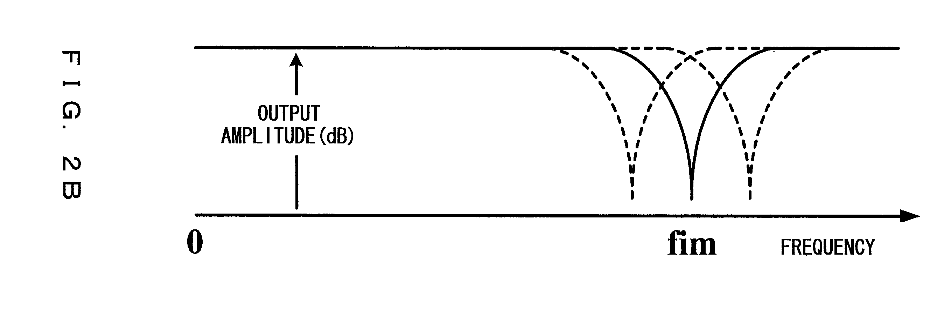

In order to remove frequency components of the above image signal, a mixer circuit including an image rejection circuit as shown in Fig. 2A is used.

Fig. 2A shows a configuration example of a mixer circuit having an image rejection circuit.

The mixer circuit shown in Fig. 2A includes at least a first mixer unit 2 for mixing a signal received by a receiver device with a first local oscillation signal generated by a local oscillator 1, a second mixer unit 3 for mixing the received signal with a second local oscillation signal obtained by shifting the local oscillation signal generated by the local oscillator 1 by 90° with a phase shifter, a polyphase filter circuit 6 including resistors R and condensers C, and a composition/output unit 5 for composing and outputting the IF signals output from the polyphase filter circuit 6.

The local oscillator 1 can consist of, for example, a quartz oscillator, and provides the local oscillation signal to the first mixer unit 2 and to the second mixer unit 3. The local oscillator 1 provides to the first mixer unit 2 a local oscillation signal IL and a signal IL' obtained by inverting the phase of the signal IL by 180°, and provides to the second mixer unit 3 a signal QL obtained by shifting the local oscillation signal IL by 90° with the phase shifter and a signal QL' obtained by inverting a phase of the signal QL by 180°.

Both the first mixer unit 2 and the second mixer unit 3 can be realized by, for example, a Gilbert Cell mixer, which are in common use.

The first mixer unit 2 mixes signals S and S' that are differential signals of the signal received by the receiver device with the local oscillation signals IL and IL' provided by the local oscillator 1, and outputs an IF signal Is and a signal Is' obtained by inverting the phase of the signal Is by 180°.

Similarly, the secondmixerunit 3 mixes the signals S and S' that are differential signals of the signal received by the receiver device with local oscillation signals QL and QL' provided by the local oscillator 1 via the phase shifter, and outputs an IF signal Qs and a signal Qs' obtained by inverting the phase of the signal Qs by 180°.

The polyphase filter circuit 6 includes the resistors R and the condensers C. As shown in Fig. 2A, the polyphase filter circuit has four inputs and four outputs in which each input terminal is connected to one output terminal via the resistor R, and is connected to the other output terminal via the condenser C.

The phases of the output signals Qs and Qs' that are output from the second mixer unit 3 and which are to be input to the polyphase filter circuit 6, are shifted by 90° from those of the signals Is and Is' that are output from the first mixer unit 2 and which are to be input to the polyphase filter circuit 6.

The composition/output unit 5 can be configured by, for example, operational amplifiers or the like. The operational amplifiers respectively compose the signals Io/Qo and the signals Io' and Qo' output from the polyphase filter circuit 6, and one of the outputs from these operational amplifiers is handled as the output of the composition/output unit 5.

When the image signal shown in Fig. 1 is input, the signals Is and Is' output from the first mixer unit 2 and the signals Qs and Qs' output from the second mixer unit 3 include frequency components of the image signal. By using the polyphase filter circuit 6, a signal is obtained that is in phase with the desired wave included in the signals Qs and Qs' output from the second mixer unit 3 and the desired wave included in the signals Is and Is' output from the first mixer unit 2, and also a signal is obtained that is in antiphase from the image signal included in the signals Qs and Qs' output from the second mixer unit 3 and the image signal included in the signals Is and Is' output from the first mixer unit 2.

Accordingly, by the composition conducted by the composition/output unit 5, the image signal is cancelled such that only a signal having a desired wave is obtained.

Patent Document 1
Japanese Patent Application Publication No. 2002-353741

Patent Document 2
Japanese Patent Application Publication No. 2003-174330

Fig. 2B shows frequency characteristics regarding the signals input into and output from the polyphase filter circuit shown in Fig. 2A.

The solid line in Fig. 2B represents the ideal frequency characteristic of the polyphase filter circuit. By adjusting the resistors R and the condensers C constituting the polyphase filter circuit, the frequency band of the image signal can be removed.

However, in general, resistors have a variation of $\pm 30\%$ and condensers have a variation of $\pm 10\%$ in their performances when a circuit is formed on a semiconductor circuit substrate by a CMOS process.

Accordingly, the polyphase filter circuit is affected by manufacturing variations in the resistors and condensers, and the cut-off frequency varies as depicted by the dashed lines in Fig. 2B such that the frequency components of the image signal cannot be rejected in a desired manner, which is problematic.

Patent Document 1 discloses a mixer circuit that can keep an excellent image rejection characteristic against the variations in the constants of the circuit elements. Patent Document 2 discloses an image rejection mixer that has a high image rejection ratio.

**Disclosure of Invention**

The present invention is achieved in view of the above problem, and it is an obj ect of the present invention to provide an image rejection circuit that can reject an image signal without being affected by manufacturing variations in circuit elements such as resistors, condensers, or the like.

The invention defined in claim 1 is of an image rejection circuit comprising at least a first mixer unit for mixing a received signal with a first local oscillation signal, a second mixer unit for mixing the received signal with a second local oscillation signal obtained by shifting a phase of the first local oscillation signal by 90°, a polyphase filter circuit which receives, as inputs to the polyphase filter circuit itself, a signal output from the first mixer unit and a signal output from the second mixer unit, and which includes a plurality of condensers and a plurality of switching elements, and a composition/output unit for composing and outputting a plurality of signals output from the polyphase filter circuit.

According to the invention defined in claim 1, the polyphase filter circuit includes condensers and switching elements such that resistors are not necessary, whereas they are necessary in conventional polyphase filter circuits. In other words, because resistors, which have great manufacturing variations, do not have to be used, it is possible to reduce influence of the manufacturing variations of the circuit elements.

The invention defined in claim 2 is of the image rejection circuit according to claim 1, in which the polyphase filter circuit includes a switched capacitor having a condenser and a switching element, and one input terminal is connected to one output terminal via the switched capacitor, and said one input terminal is connected to other output terminals via a condenser.

According to the invention defined in claim 2, because the polyphase filter circuit is constituted of the condensers and the switched capacitors, it is possible to determine the cut-off frequency of the polyphase filter circuit on the basis of the ratio of the condenser such that the image signal can be rejected without being affected by the manufacturing variations of the circuit elements.

The invention defined in claim 3 is of the image rejection circuit according to claim 2, in which the polyphase filter circuit is configured and used as a multistage polyphase filter circuit.

According to the invention defined in claim 3, similarly to claim 2, because the polyphase filter circuit is constituted of the condensers and the switched capacitors, it is possible to determine the cut-off frequency of the polyphase filter circuit on the basis of the ratio of the condenser such that the image signal can be rejected without being affected by the manufacturing variations of the circuit elements.

As described above, according to the present invention, it is possible to provide the image rejection circuit that can reject the image signal without being affected by manufacturing variations in circuit elements such as resistors, condensers, or the like.

**Brief Description of Drawings**

Fig. 1 schematically shows an image signal;
Fig. 2A shows an example of a configuration of a mixer circuit having an image rejection circuit;
Fig. 2B schematically shows a characteristic of the mixer circuit having the image rejection circuit;
Fig. 3A shows a configuration example in which the image rejection circuit according to an embodiment of the present invention is applied to the mixer circuit;
Fig. 3B shows a configuration example of a switched capacitor used in the image rejection circuit according to an embodiment of the present invention.

**Best Modes for Carrying Out the Invention**

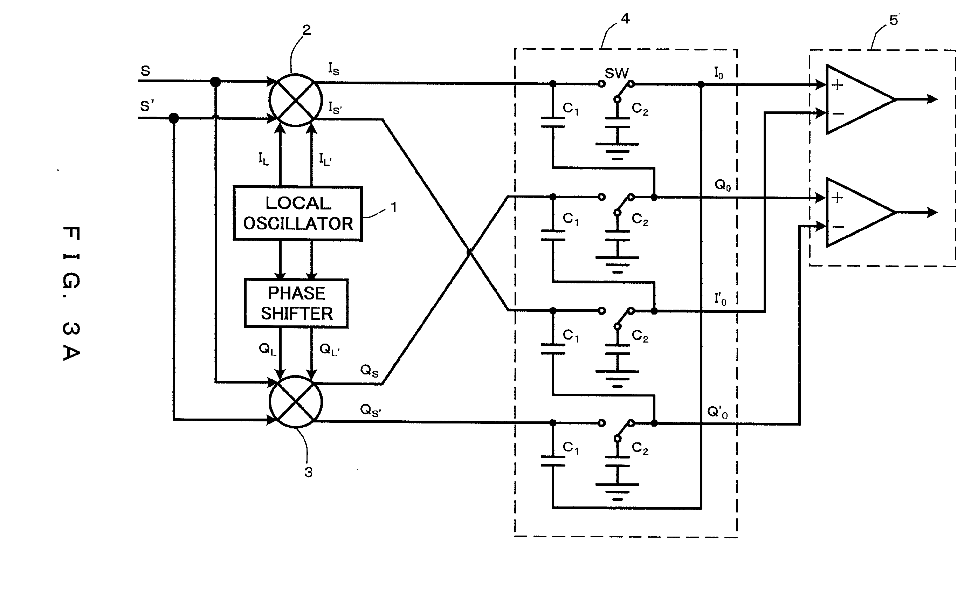

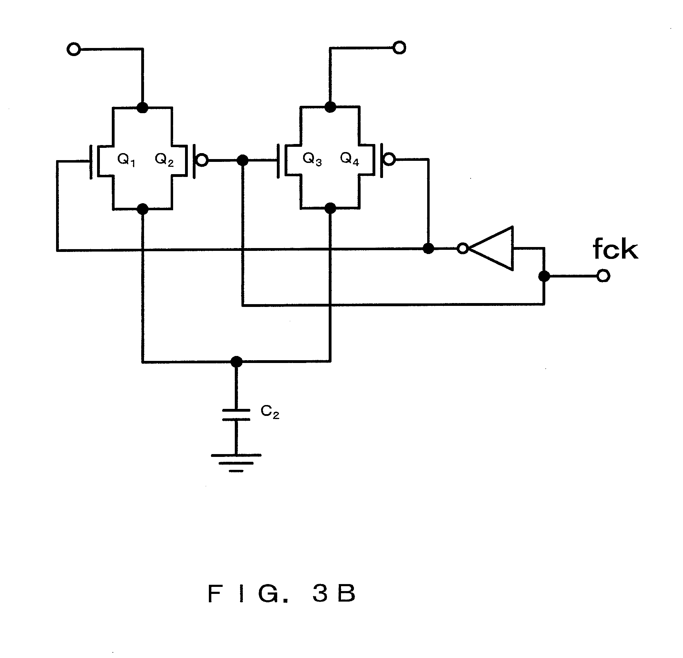

Hereinafter, embodiments of the present invention will be explained by referring to Fig. 1 and Fig. 3. The circuits according to the present embodiment are formed on a semiconductor circuit substrate by a CMOS process that can fabricate p-channel and n-channel MOS transistors.

Fig. 3A shows a configuration example in which the image rejection circuit according to the present embodiment is applied to a mixer circuit.

The mixer circuit shown in Fig. 3A comprises at least a first mixer unit 2 for mixing a signal received by a receiver device with a first local oscillation signal generated by a local oscillator 1, a second mixer unit 3 for mixing the received signal with a second local oscillation signal obtained by shifting the local oscillation signal generated by the local oscillator 1 by 90°, a polyphase filter circuit 4 including condensers C1 and switched capacitors, and a composition/output unit 5 for composing and outputting the IF signals output from the polyphase filter circuit 4. The local oscillator 1 may comprise, for example, a quartz oscillator, and provides the local oscillation signal to the first mixer unit 2 and to the second mixer unit 3. The local oscillator 1 provides to the first mixer unit 2 a local oscillation signal IL and a signal IL' obtained by inverting the phase of the signal IL by 180°, and provides to the second mixer unit 3 a signal QL obtained by shifting the local oscillation signal IL by 90° with a phase shifter, and a signal QL' obtained by inverting the phase of the signal QL by 180°.

Both the first mixer unit 2 and the second mixer unit 3 can be realized by, for example, a Gilbert Cell mixer, which are in common use.

The first mixer unit 2 mixes signals S and S' that are differential signals of the signal received by the receiver device with the local oscillation signals IL and IL' provided by the local oscillator 1, and outputs an IF signal Is and a signal Is' obtained by inverting the phase of the signal Is by 180°.

Similarly, the second mixer unit 3 mixes the signals S and S' that are differential signals of the signal received by the receiver device with local oscillation signals QL and QL' provided by the local oscillator 1 via the phase shifter, and outputs an IF signal Qs and a signal Qs' obtained by inverting the phase of the signal Qs by 180°.

The polyphase filter circuit 4 includes the condensers C1 and switched capacitors consisting of condensers C2 and switches SW. As shown in Fig. 3A, the polyphase filter circuit has four inputs and four outputs in which each input terminal is connected to one output terminal via the switched capacitor consisting of the condenser C2 and the switch SW, and is connected to the other terminal via the condenser C1.

In the polyphase filter circuit 4 of this configuration, four switched capacitors are used. Each of these switched capacitors consists of the condenser C2 and the switch SW, as described above, in which the switch SW is connected to GND via the condenser C2 and the condenser C2 is selectively connected to the input side and the output side of the polyphase filter circuit 4 via the switch SW.

The switches SW used in the switched capacitors may be implemented by, for example, MOS transistors (see Fig. 3B, which will be described later).

The phases of the signals Qs and Qs' that are output from the second mixer unit 3 and that are to be input to the polyphase filter circuit 4 are shifted by 90° from the signals Is and Is' output from the first mixer unit 2 and which are to be input to the polyphase filter circuit 4.

The above-described switched capacitors consisting of the condensers C2 and the switches SW operate substantially as resistors. Therefore, the polyphase filter circuit 4 of Fig. 3A and the polyphase filter circuit 6 of Fig. 2A are substantially equivalent to each other.

The composition/output unit 5 can be configured by, for example, operational amplifiers or the like. The operational amplifiers respectively compose the signals Io/Qo and the signals Io' and Qo' output from the polyphase filter circuit 4, and one of the outputs from these operational amplifiers is handled as the output of the composition/output unit 5.

Fig. 3B shows an example of a configuration of the switched capacitor used in the above present embodiment.

The switched capacitor shown in Fig. 3B comprises a so-called transfer gate in which an n-type MOS transistor Q1 and a p-type MOS transistor Q2 are connected in parallel, a transfer gate in which an n-type MOS transistor Q3 and a p-type MOS transistor Q4 are connected in parallel, the condenser C2, and a NOT circuit.

The switched capacitor also comprises a control circuit (not shown) that generates a control signal having a switching frequency fck by using, for example, a quartz oscillator or the like, and provides the control signal to the gates of the MOS transistors constituting the above transfer gates for controlling the on/off states of the switches SW. Also, known switched capacitors that have configurations other than the configuration described in the present embodiment may be used as the switched capacitors constituting the polyphase filter circuit according to the present embodiment.

When the image signal shown in Fig. 1 is input, the signals Is and Is' output from the first mixer unit 2, and the signals Qs and Qs' output from the second mixer unit 3 include frequency components of the image signal. By using the polyphase filter circuit 4, a signal is obtained that is in phase with the desired wave included in the signals Qs and Qs' output from the second mixer unit 3 and the desired wave included in the signals Is and Is' output from the first mixer unit 2, and a signal is also obtained that is in antiphase from the image signal included in the signals Qs and Qs' output from the second mixer unit 3 and the image signal included in the signals Is and Is' output from the first mixer unit 2.

Accordingly, by the composition conducted by the composition/output unit 5, the image signal is cancelled such that only the signal having a desired wave is obtained.

Equivalent resistance Rs of the switched capacitor used in the polyphase filter circuit 4 according to the present invention is expressed by the equation

$$Rs=1/(fck*C2) , \quad (1)$$

where the switching frequency of the switch SW is fck.

The cut-off frequency fc of the polyphase filter circuit 4 according to the present embodiment is expressed by the equation below using the equivalent resistance Rs of the switched capacitor.

$$fc=1/(2\pi*C1*Rs) \quad (2)$$

Therefore, the cut-off frequency fc of the polyphase filter circuit 4 according to the present embodiment is expressed by the equation below obtained from equations (1) and (2).

$$fc=(fck*C2)/(2\pi*C1)=(fck/2\pi) * (C2/C1) \quad (3)$$

In equation (3), fck/2π can be assumed to be constant because a very precise and constant switching frequency fck can be obtained by using, for example, a quartz oscillator or the like for switching of the switch SW.

It is known that when a circuit is formed on a semiconductor circuit substrate by a CMOS process, manufacturing variations are the same among circuit elements. For example, when the capacitance of the condenser C1 increases by about 5% due to manufacturing variations, the capacitance of the condenser C2 also increases by about 5%.

Accordingly, C2/C1 in equation (3) is determined by a ratio between the capacitance of the condenser C1 and the capacitance of the condenser C2, and the manufacturing variations are cancelled.

As described above, by using the polyphase filter circuit 4 according to the present embodiment, the cut-off frequency fck can be determined by the ratio between the condenser C1 and the condenser C2 constituting the polyphase filter circuit 4, such that it is possible to avoid the effects of manufacturing variations in circuit elements such as resistors, condensers and the like.

The polyphase filter circuit explained in the present embodiment is a polyphase filter circuit having a single-stage configuration; however, the scope of the present invention is not limited to this configuration. Specifically, for example, by configuring the polyphase filter circuit according to the present embodiment to have two stages or more such that it serves as a multistage filter, it is possible to expand a bandwidth of the cut-off frequency.

It is also to be noted that only the condensers C1 and C2 constitute the polyphase filter circuit 4 according to the present embodiment in the above explanation; however, the scope of the present invention is not limited to this configuration. It is also possible to use appropriate condensers that are different in capacitance (or in type) in order to obtain the desired cut-off frequency.

Further, it is also to be noted that the polyphase filter circuit 4 according to the present embodiment is constituted of the switched capacitors in the explanation; however, the scope of the present invention is not limited to this configuration. Any circuit that includes circuits constituted of condensers and switching elements equivalent to the resistors shown in Fig. 2 can be used as the polyphase filter circuit 4.

**Claims**

1.  An image rejection circuit comprising at least:

    a first mixer unit for mixing a received signal with a first local oscillation signal;
    a second mixer unit for mixing the received signal with a second local oscillation signal obtained by shifting the phase of the first local oscillation signal by 90°;
    a polyphase filter circuit which receives, as inputs to the polyphase filter circuit itself, a signal output from the first mixer unit and a signal output from the second mixer unit, and which includes a plurality of condensers and a plurality of switching elements; and
    a composition/output unit for composing and outputting a plurality of signals output from the polyphase filter circuit.

2.  The image rejection circuit according to claim 1, wherein:

    the polyphase filter circuit includes a switched capacitor having a condenser and a switching element; and
    one input terminal is connected to one output terminal via the switched capacitor, and said one input terminal is connected to other output terminals via a condenser.

3.  The image rejection circuit according to claim 2, wherein:

    the polyphase filter circuit is configured and used as a multistage polyphase filter circuit.

F I G. 1

EP 1 758 241 A1

F I G. 2 A

F I G. 2 B

F I G. 3 A

F I G. 3 B

## INTERNATIONAL SEARCH REPORT

| | International application No. |
|---|---|
| | PCT/JP2005/009578 |

A.   CLASSIFICATION OF SUBJECT MATTER
    Int.Cl⁷ H03D7/18, H04B1/26

According to International Patent Classification (IPC) or to both national classification and IPC

B.   FIELDS SEARCHED

Minimum documentation searched (classification system followed by classification symbols)
    Int.Cl⁷ H03D7/00-7/22, H04B1/26-1/28

Documentation searched other than minimum documentation to the extent that such documents are included in the fields searched
    Jitsuyo Shinan Koho            1922-1996   Jitsuyo Shinan Toroku Koho   1996-2005
    Kokai Jitsuyo Shinan Koho      1971-2005   Toroku Jitsuyo Shinan Koho   1994-2005

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| Y | JP 2002-353741 A  (Aruefu Chippusu Tekunorogi Kabushiki Kaisha), 06 December, 2002 (06.12.02), Full text; all drawings (Family: none) | 1-3 |
| Y | JP 05-259899 A  (SGS-Thomson Microelectronics GmbH.), 08 October, 1993 (08.10.93), Column 2, line 31 to column 3, line 21; Fig. 10 & US 5376891 A1          & EP 0540906 & DE 4135644 C1 | 1-3 |

☒ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 23 August, 2005 (23.08.05) | 06 September, 2005 (06.09.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

International application No.

PCT/JP2005/009578

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 60-058705 A  (Hitachi, Ltd.),<br>04 April, 1985 (04.04.85),<br>Page 2, upper left column, line 14 to upper<br>right column, line 9; Fig. 1<br>(Family: none) | 1-3 |
| Y | Microfilm of the specification and drawings<br>annexed to the request of Japanese Utility<br>Model Application No. 079176/1979 (Laid-open<br>No. 179405/1980)<br>(Toko, Inc.),<br>23 December, 1980 (23.12.80),<br>Page 1, line 20 to page 2, line 13<br>(Family: none) | 1-3 |

Form PCT/ISA/210 (continuation of second sheet) (January 2004)

**EP 1 758 241 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002353741 A

- JP 2003174330 A